# EUROPÄISCHE PATENTSCHRIFT

(11) **EP 3 378 289 B1**
(45) Veröffentlichungstag und Bekanntmachung des Hinweises auf die Patenterteilung: **20.07.2022**
(21) Anmeldenummer: 16795271.2
(22) Anmeldetag: 07.11.2016
(51) Int. Cl.: H05K 1/02, H05K 3/32, H05K 7/14

(54) **LEITERPLATTE ZUM MECHANISCHEN FIXIEREN EINES GEHÄUSES**
CIRCUIT BOARD FOR MECHANICALLY FASTENING A HOUSING
CARTE DE CIRCUIT IMPRIMÉ PERMETTANT LA FIXATION MÉCANIQUE D'UN BOÎTIER

(30) Priorität: 19.11.2015 DE 102015222874
(43) Veröffentlichungstag der Anmeldung: 26.09.2018
(73) Patentinhaber: Tridonic GmbH & Co. KG, 6851 Dornbirn (AT)
(72) Erfinder: WEBER, Wolfgang, 6972 Fußach (AT)
(74) Vertreter: Rupp, Christian
(86) Internationale Anmeldenummer: PCT/EP2016/076879
(87) Internationale Veröffentlichungsnummer: WO 2017/084906

(56) Entgegenhaltungen:
- DE-U1- 9 115 131
- GB-A- 2 474 509
- US-B1- 6 186 800
- US-B1- 6 695 629

## Beschreibung

Die Erfindung betrifft ein System aus Leiterplatte und Gehäuse, bevorzugt für eine Schaltung zum Betreiben eines Leuchtmittels, beispielsweise eine Treiberschaltung, englisch Ballast, oder ein elektronisches Vorschaltgerät, kurz EVG. Die Erfindung betrifft dabei insbesondere das Optimieren einer Halteverbindung zwischen dem Gehäuse und der Leiterplatte.

Schaltungen zum Betreiben wenigstens eines Leuchtmittels, beispielsweise einer LED oder Gasentladelampe, werden bevorzugt auf einer Leiterplatte angeordnet. Zum Schutz dieser Schaltung vor äußeren Einflüssen, wie Schmutz, mechanischer Zerstörung, Feuchtigkeit oder elektromagnetischer Strahlung sowie zum Schutz von Mensch und Umwelt vor der Schaltung, beispielsweise durch Berühren spannungsführender Teile der Schaltung oder durch die ausgesendete elektromagnetische Strahlung der Schaltung, wird die Leiterplatte mit einem Gehäuse versehen. Dabei kann das Gehäuse neben der Leiterplatte noch zusätzliche Elemente beherbergen.

Ist das Gehäuse beispielsweise aus einem metallischen Material, so ist aus sicherheitstechnischen Gründen zudem zu gewährleisten, dass ein Erdpotenzial einer Spannungsversorgung mit dem Gehäuse verbunden wird.

Üblicherweise wird eine mechanische Halteverbindung, insbesondere eine Klemmverbindung zwischen Gehäuse und Leiterplatte durch ein Halteelement des Gehäuses ermöglicht. Dieses Halteelement wird durch eine Durchbohrung der Leiterplatte geführt und mittels eines Haltebügels mechanisch fixiert. Dabei hat das Halteelement des Gehäuses keinen oder keinen ausreichenden physischen Kontakt mit der Innenwand der Durchbohrung der Leiterplatte. Auf diese Weise kann bei mechanischer Beanspruchung der Leiterplatte, beispielsweise beim Testen der Leiterplatte oder beim elektrischen Kontaktieren oder bei der Installation der Schaltung in dem Beleuchtungssystem die Halteverbindung stark verschlechtert werden.

Herkömmlich kann das Gehäuse also nur unzureichend an der Leiterplatte mechanisch fixiert werden. Ist die mechanische Halteverbindung labil, ist kein ausreichender Schutz der Leiterplatte vor den äußeren Einflüssen bzw. kein Schutz der Umwelt vor den Einflüssen der Leiterplatte gewährleistet.

Überdies ist aufgrund des unzureichenden physischen Kontakts zwischen der Durchbohrung und dem Halteelement des Gehäuses eine Verringerung der Haltekraft bzw. der Klemmkraft des Halteelements möglich, was zu einer zusätzlichen Verschlechterung des mechanischen Fixierens führt. Dieses verschlechterte mechanische Fixieren kann insbesondere zu einer Verschlechterung der Erdpotentialverbindung zwischen Gehäuse und Leiterplatte führen und speziell beim Testen oder Inbetriebnahme der Schaltung zu Störungen oder Ausfällen des Leuchtmittels führen.

Dokument US6695629 offenbart ein Montage- und Verbindungsschema für eine Leiterplatte mit niedrigem Profil und verwendet einen leitenden Abstandshalter mit einer Schulter, einem Schaft und einem Kopf. Eine auf dem Abstandshalter zu montierende Leiterplatte definiert ein Durchgangsloch, das in einen Kanal mündet. Das Durchgangsloch ist ausreichend groß, um den Kopf des Abstandshalters freizugeben, und der Kanal ist ausreichend breit, um den Schaft freizugeben, aber nicht die Schulter. Ein leitender, bügelförmiger Clip hat zwei federnde Ausläufer. Der Clip ist an der Leiterplatte montiert, so dass die Ausläufer entlang jeder Seite eines Abschnitts des Kanals angeordnet sind. Die Ausläufer können sich in einer Ebene, die parallel zur Ebene der Leiterplatte ist, aufeinander zu und voneinander weg bewegen. Die Ausläufer greifen in den Kopf ein, um eine elektrische Verbindung herzustellen, wenn der Schaft zum Ende des Kanals bewegt wird.

Es ist daher Aufgabe der hier vorliegenden Erfindung eine Leiterplatte zur Verfügung zu stellen, die mittels eines Gehäuses zuverlässig geschützt werden kann, wobei die mechanische Halteverbindung des Gehäuses an der Leiterplatte wesentlich verbessert werden soll. Insbesondere soll auch eine elektrische Verbindung zum Anlegen eines Erdungspotentials zwischen dem Gehäuse und der Leiterplatte zuverlässiger ausgebildet werden, um die Sicherheit im Umgang mit dem Gehäuse zu verbessern. Dabei ist darauf zu achten, dass die als Massenprodukt hergestellte elektronische Schaltung für ein Leuchtmittel keine erhöhten Herstellungskosten aufweist und eine einfach Herstellung weiterhin garantiert ist.

Diese Aufgabe wird mit den in den nebengeordneten Patentansprüchen beschriebenen technischen Merkmalen gelöst. Bevorzugte Ausgestaltungen sind in den jeweils abhängigen Ansprüchen beschrieben.

Gemäß Erfindung ist eine Leiterplatte, bevorzugt für eine Schaltung zum Betreiben eines Leuchtmittels, vorgesehen. Das Leuchtmittel ist bevorzugt wenigstens eine LED. Die Leiterplatte weist einen Haltebügel auf, der auf einer flächigen Oberseite der Leiterplatte angeordnet ist und mechanisch mit der Leiterplatte verbunden ist. Somit ist ein Haltebügel vorgesehen, der fix auf der Leiterplatte angeordnet ist. Das mechanische Verbinden des Haltebügels ist beispielsweise ein lösbares Fixieren, wie Löten, Schrauben oder Klemmen ermöglicht, oder ein unlösbares Fixieren, beispielsweise durch Kleben oder Nieten. Der Haltebügel ist somit dazu eingerichtet, ein Gehäuse an der Leiterplatte zu halten, um der Leiterplatte einen Schutz zu bieten.

Die Leiterplatte weist zudem eine Durchbohrung auf, die zumindest teilweise unterhalb des Haltebügels angeordnet ist. Die Durchbohrung ist dabei von der

Oberseite der Leiterplatte zu einer gegenüberliegenden Unterseite der Leiterplatte ausgebildet.

Die Durchbohrung weist erfindungsgemäß zumindest eine konstruktive Verjüngung auf. Diese Verjüngung schränkt die Bewegungsfreiheit des Halteelements eines Gehäuses innerhalb der Durchbohrung wesentlich ein. Durch die Verjüngung wird insbesondere gewährleistet, dass das Halteelement mit der Durchbohrung in einem physischen Kontakt steht. Die Verjüngung ist beispielsweise ein Vorsprung oder eine Einengung innerhalb der Durchbohrung. Diese Verjüngung reduziert partiell den Innendurchmesser der Durchbohrung.

Ein Gehäuse kann so zum Schutz der Leiterplatte mittels des Haltebügels und der Verjüngung verbessert mechanisch fixiert werden. Durch die fehlende beziehungsweise sehr stark eingeschränkte Bewegungsfreiheit des Halteelements sitzt das Gehäuse sehr straff an der Leiterplatte und kann sich bei physischer Beanspruchung der Leiterplatte relativ zum Gehäuse nicht lösen. Durch die stark minimierte Bewegungsfreiheit wird zudem sichergestellt, dass die Halteverbindung über einen langen Zeitraum bei bestimmungsgemäßer Verwendung (Testen, Verdrahten etc.) der Schaltung stabil bleibt und somit kein Lösen des Gehäuses von der Leiterplatte zu Befürchten ist. Auf diese Weise wird ein loses Verbinden, beispielsweise Wackeln, des Gehäuses aufgrund der fehlenden mechanischen Fixierung in der Durchbohrung verhindert. Die Verjüngung gewährleistet einen straffen Sitz des Gehäuses bzw. des Halteelements des Gehäuses innerhalb der Durchbohrung, wodurch auch ein späteres Beanspruchen der Leiterplatte, beispielsweise zum Testen der Treiberschaltung oder dem Verdrahten der Schaltung bei Inbetriebnahme des Beleuchtungssystems nicht dazu führt, dass das Gehäuse sich von der Leiterplatte löst und so möglicherweise kein Schutz vor elektromagnetischer Strahlung, Feuchtigkeit oder Schmutz gewährleistet ist.

Diese Einschränkung der Bewegungsfreiheit des Gehäuses durch die Verjüngung wirkt bereits beim Applizieren des Gehäuses auf der Leiterplatte vorteilhaft, da der Bewegungsradius des Gehäuses eingeschränkt ist. Somit kommt es nicht zu einem Auseinanderbiegen des Halteelementes des Gehäuses beim Applizieren und somit auch nicht durch relatives Verschieben der Leiterplatte im Gehäuse zu einer Lockerung dieser mechanischen Halteverbindung.

In einer bevorzugten Ausgestaltung ist der Haltebügel elektrisch leitend mit einem Erdpotential verbunden. Somit erfüllt die Verjüngung eine Doppelfunktion, da nun das Gehäuse einerseits mechanisch mit der Leiterplatte fixierbar ist und zudem auch gleichzeitig eine zuverlässige elektrische Verbindung zwischen Gehäuse und Leiterplatte hergestellt ist.

Bevorzugt sind die Gehäuse für elektronische Vorschaltgeräte aus Metall, um beispielsweise eine mechanische und auch Abschirmung gegenüber elektromagnetischer Strahlung zu gewährleisten. Die Erdung des Gehäuses mittels des Erdungspotenzials hat zum Ziel, ein definiertes Bezugspotential oder einen Potentialausgleich herzustellen, durch den eine fehlerhaft am Gehäuse auftretende Spannung kurzgeschlossen werden soll. Gemäß standardisierten Vorschriften in der Gebäudetechnik ist es nötig, dass metallische Gehäuse mit einem Erdungspotential beaufschlagt werden.

Durch das Verbessern der mechanischen Halteverbindung wird auch der elektrische Kontakt zwischen Gehäuse und Leiterplatte verbessert. Eine lose Halteverbindung führt zu einer schwachen oder teilweise unterbrochenen elektrischen Verbindung. Die Sicherheit und auch die Funktionalität einer derartigen Leiterplatte sind somit wesentlich erhöht. Das Ausbilden des Haltebügels als Erdungsleitung ermöglicht eine effiziente Herstellung einer Schaltung zum Betreiben des Leuchtmittels, da mit einer Verbindung die Doppelfunktion sicher hergestellt wird. Insbesondere das Ausgestalten der Durchbohrung mit einer Verjüngung sorgt dafür, dass die Erdungsleitung stets mit dem Gehäuse kontaktiert - also eingespannt - ist, sodass auch beim Testen der Schaltung auf der Leiterplatte oder dem Installieren im Beleuchtungssystem eine entsprechende elektrische und mechanische Verbindung gewährleistet ist.

Die Durchbohrung ist bei Draufsicht auf die Leiterplatte ein Langloch, wobei die Längsseiten des Langlochs in einem Wickel größer o Grad, bevorzugt größer 10 Grad, mehr bevorzugt größer 30 Grad unterhalb des Haltebügels verläuft.

Bei Draufsicht auf die Oberseite der Leiterplatte kreuzt die Durchbohrung den Haltebügel in einem Winkel größer o Grad. Durch Vergrößern des Winkels zwischen der Längsseite und dem Haltebügel wird die Haltekraft vergrößert, da das Halteelement nunmehr eher quer als längs zum Haltebügel ausgerichtet ist und der Abstand zwischen Halteelement und Haltebügel verkleinert wird.

Ein Langloch ist dabei eine längliche Durchbohrung. Seine schmalen Querseiten werden bevorzugt durch Halbkreise abgeschlossen, deren Durchmesser der Breite des Langlochs entsprechen. Die Längsseiten des Langloches verlaufen bevorzugt parallel zueinander. Durch die Verwendung eines Langlochs als Durchbohrung wird gewährleistet, dass ein Halteelement mit größeren Abmessungen verwendet wird, wodurch massivere Gehäuse verwendbar sind oder eine größere Haltekraft ermöglicht ist.

Wird nun ein Halteelement des Gehäuses verwendet, welches beispielsweise zwei Haltelaschen und einen mittig verlaufenden Schlitz aufweist, so kann das Halteelement in dem Langloch derart angeordnet werden, dass jede Haltelasche durch den Haltebügel und die Verjüngung eingespannt ist.

In einer bevorzugten Ausgestaltung ist die Durchbohrung bei Draufsicht auf die Leiterplatte ein Langloch, wobei zumindest zwei Verjüngungen an entgegengesetzten Längsseiten der Durchbohrung angeordnet sind. Auf diese Weise wird das Gehäuse in der Durchbohrung verbessert gehalten, da nunmehr zwei entgegengesetzte Verjüngungen und der Haltebügel das Gehäuse innerhalb der Durchbohrung der Leiterplatte mechanisch fixieren. Die Verjüngungen sind beispielsweise nahe der Halbkreise des Längslochs angeordnet.

In einer bevorzugten Ausgestaltung ist die zumindest eine Verjüngung trapezförmig ausgebildet, wobei eine verjüngende Seite der Verjüngung parallel zu einer Längsseite der Durchbohrung verläuft. Eine trapezförmige Ausgestaltung der Verjüngung ist einfach herstellbar und ermöglicht zudem einen großen überlappenden Bereich zwischen der Durchbohrung und dem Halteelement. Auf diese Weise ist eine größere Fläche des Halteelements des Gehäuses mit der Durchbohrung physisch kontaktiert, sodass eine vergrößerte mechanische Fixierung erwirkt ist. Auf diese Weise ist das Gehäuse verbessert an der Leiterplatte angeordnet.

In einer weiter bevorzugten Ausgestaltung ist der Haltebügel mittels einer Lötverbindung auf der Leiterplatte angeordnet. Auf diese Weise ist der Haltebügel durch eine vereinfachte Herstellung auf der Leiterplatte mechanisch verbindbar. Somit wird die Leiterplatte mit dem Haltebügel ähnlich wie alle Schaltungselemente der Schaltung auf der Leiterplatte bestückt, wodurch kein zusätzlicher Herstellungsprozess benötigt wird, um den Haltebügel mit der Leiterplatte zu verbinden. Der Haltebügel kann als nichtisoliertes Drahtelement ausgebildet sein, beispielweise als Kupferdraht, Nickel- oder Eisendraht. Der Haltebügel kann galvanisch beschichtet sein, zum Beispiel mit Zinn, Silber oder Edelmetallen. Der Haltebügel kann als bogenförmige Erhebung ausgebildet sein.

In einer bevorzugten Ausgestaltung sind Schaltungselemente einer Schaltung zum Betreiben eines Leuchtmittels auf einer der Oberseite gegenüberliegenden Unterseite der Leiterplatte angeordnet. Auf diese Weise schützt das Gehäuse die Schaltung unterhalb des Gehäuses, wobei das Gehäuse durch die Leiterplatte hindurch gesteckt wird und in der Durchbohrung fixiert ist.

In einer alternativen Ausgestaltung sind Schaltungselemente einer Schaltung zum Betreiben eines Leuchtmittels auf der Oberseite der Leiterplatte angeordnet. Somit ist keine zweiseitige Bestückung der Leiterplatte nötig, um einerseits eine mechanische Halteverbindung und andererseits eine zuverlässige elektrische Verbindung zwischen Gehäuse und Leiterplatte herzustellen. Durch das Einspannen der Halteelemente mittels Verjüngung und Haltebügel ist ein einseitiges Bestücken der Leiterplatte ermöglicht. Überdies stellt der Haltebügel sodann keine Erhöhung auf der Oberseite der Leiterplatte dar. Da der Haltebügel nunmehr auf der Seite der Schaltungselemente angeordnet ist und die Höhe des Haltebügels geringer ist als die Höhe der Schaltungselemente, ist eine Miniaturisierung der Schaltung bewirkt.

In einer bevorzugten Ausgestaltung ist der Haltebügel im Inneren der Leiterplatte angeordnet, also insbesondere zwischen der Oberseite der Leiterplatte und der gegenüberliegenden Unterseite. Dadurch wird der Haltebügel in die Leiterplatte integriert und stellt keine Erhöhung auf der Oberseite bzw. Unterseite der Leiterplatte dar. Somit kann eine Miniaturisierung der Leiterplatte ermöglicht werden.

In einer bevorzugten Ausgestaltung ist mittels der Verjüngung die Durchbohrung um mindestens 10 Prozent, bevorzugt 15 Prozent, mehr bevorzugt 20 Prozent verjüngt. Diese unterschiedlichen Verjüngungsgrade ermöglichen einen unterschiedlichen Grad an Einspannung. Je größer der Verjüngungsgrad ist, umso größer ist die Haltekraft der Halteverbindung zwischen Gehäuse und Leiterplatte.

Gemäß einem Aspekt der Erfindung ist ein System nach Anspruch 1 für eine Schaltung zum

Betreiben zumindest eines Leuchtmittels bestehend aus einer Leiterplatte gemäß der vorhergehend beschriebenen Art und einem Gehäuse vorgeschlagen. Das Gehäuse dient dem Schutz vor äußeren Einflüssen, wie Feuchtigkeit, Schmutz, etc. und der elektromagnetischen Abschirmung der auf der Leiterplatte angeordneten Schaltung. Das Gehäuse kann auch zusätzlich die Funktion eines Kühlelementes übernehmen. Es wäre auch möglich, dass zusätzlich eine Kunststoffabdeckung unterhalb des Gehäuses platziert wird, um das Gehäuse elektrisch von der Umgebung des Systems abzuschirmen.

Das Gehäuse weist zumindest ein Halteelement auf, welches in der Durchbohrung platziert ist, um das Gehäuse mittels des Haltebügels und der Verjüngung mechanisch an der Leiterplatte zu fixieren. Beispielsweise sind bei einer rechteckigen Leiterplatte zusätzlich vier Öffnungen an den Ecken bzw. am Randbereich der Leiterplatte vorgesehen, in denen erfindungsgemäß vier Positionierelemente des Gehäuses platzierbar sind, um die mechanische und ggf. elektrische Verbindung zwischen Gehäuse und Leiterplatte herzustellen. Zusätzlich sind beispielsweise ein oder zwei Durchbohrungen in der Leiterplatte vorgesehen, in denen erfindungsgemäß ein oder zwei Halteelemente des

Gehäuses platzierbar sind, um die mechanische und ggf. elektrische Verbindung zwischen Gehäuse und Leiterplatte herzustellen.

Bevorzugt ist das Halteelement ein Hochriss aus dem Gehäuse. Ein Hochriss wird nachfolgend als ein Mittels eines Fertigungsverfahrens herstellten Halteelements verstanden. Dabei werden beispielsweise Teile des Gehäuses ausgestanzt und der innere Bereich der Ausstanzung wird entsprechend umgebogen. Somit entsteht ein Halteelement, welches aus dem gleichen Material des Gehäuses und durch einfache Materialbearbeitung gewonnen wird.

Das Halteelement weist zumindest zwei Haltelaschen auf, wobei die Haltelaschen bevorzugt gleich ausgebildet sind. Mittig zwischen den Laschen befindet sich ein Schlitz, der beispielsweise in einem Stanz oder Schneideprozess hergestellt wurde. Wird nun ein derartiges Halteelement des Gehäuses in der Durchbohrung fixiert so werden die Haltelaschen vom Haltebügel getrennt. Es entsteht eine Verspannung in der Form, dass jede Haltelasche mittels einer Verjüngung der Durchbohrung und dem Haltebügel eingespannt ist.

Bevorzugt wird das Halteelement mit der ersten Haltelasche an dem Haltebügel und einer ersten Verjüngung mechanisch fixiert. Zudem wird die zweite Haltelasche mittels des Haltebügels und einer zweiten Verjüngung mechanisch fixiert. Auf diese Weise erfolgt ein Einspannen des Halteelements, wobei der Haltebügel durch einen Schlitz zwischen den Haltelaschen verläuft. Die Verjüngung ist nun dazu vorgesehen, dass jeweils eine Seite der Haltelasche direkt physischen Kontakt mit dem Inneren der Durchbohrung aufweist. Auf diese Weise hat nach dem Applizieren des Gehäuses auf der Leiterplatte das Halteelement in der Durchbohrung keine Bewegungsfreiheit mehr und ist eingespannt. Somit können die Haltelaschen des Halteelements beim Applizieren nicht über ein bestimmtes Maß hinaus auseinandergebogen werden, sodass auch bei physischer Kraftbeanspruchung der Leiterplatte relativ zum Gehäuse die mechanische Halteverbindung und somit zwangsläufig auch eine elektrische Verbindung nicht löst.

Es ist zumindest eine Lasche des Halteelements durch die Verjüngung und den Haltebügel in der Durchbohrung mechanisch fixiert.

In einer bevorzugten Ausgestaltung weist die zumindest eine Haltelasche des Halteelements eine Längsseite auf, wobei diese Längsseite der Haltelasche zumindest zu 25 Prozent an der Verjüngung anliegt. Auf diese Weise ist die Haltelasche über einen Großteil der Durchbohrung physisch mit der Leiterplatte in Kontakt und insbesondere durch den Haltebügel und die Verjüngung mechanisch fixiert. Auf diese Weise sind eine sehr stabile Halteverbindung und eine zuverlässige Erdungsleitung erhalten.

In einem weiteren Aspekt der Erfindung ist ein Verfahren zum Fixieren eines Gehäuses an einer Leiterplatte entsprechend Anspruch 12 vorgesehen. Das Verfahren umfasst die Verfahrensschritte: Anordnen eines Haltebügels mittels Lötverbindung auf der Oberseite der Leiterplatte oberhalb einer zumindest eine Verjüngung aufweisenden Durchbohrung oder Anordnen eines Haltebügels im Inneren der Leiterplatte in einer zumindest eine Verjüngung aufweisenden Durchbohrung; Platzieren eines Halteelements des Gehäuses im Inneren der Durchbohrung; wobei das Halteelement zumindest zwei Haltelaschen und einen zwischen den Haltelaschen angeordneten Schlitz aufweist; und wobei der Haltebügel durch den Schlitz geführt ist, sodass das Halteelement durch den Haltebügel und die Verjüngung mechanisch fixiert ist und jeweils eine Haltelasche auf einer Seite des Haltebügels bei Draufsicht angeordnet ist, wobei die Durchbohrung bei Draufsicht auf die Leiterplatte ein Langloch ist, wobei bei Draufsicht auf die Oberseite die Durchbohrung den Haltebügel in einem Winkel größer 0 Grad kreuzt, und wobei jede Haltelasche des Halteelements durch die Verjüngung und den Haltebügel in der Durchbohrung mechanisch fixiert ist.

Nachfolgend wird anhand von Figuren die Erfindung bzw. weitere Ausführungsformen und Vorteile der Erfindung näher Erläutert, wobei die Figuren lediglich Ausführungsbeispiele der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein.

Es zeigen:
- Fig. 1: ein erstes Ausführungsbeispiel eines erfindungsgemäßen Systems;
- Fig. 2a: ein erstes Ausführungsbeispiel einer erfindungsgemäßen Leiterplatte;
- Fig. 2b: ein zweites Ausführungsbeispiel eines erfindungsgemäßen Systems;
- Fig. 3a: ein drittes Ausführungsbeispiel eines erfindungsgemäßen Systems;
- Fig. 3b: ein viertes Ausführungsbeispiel eines erfindungsgemäßen Systems;
- Fig. 4: ein fünftes Ausführungsbeispiel eines erfindungsgemäßen Systems;
- Fig. 5: ein zweites Ausführungsbeispiel einer erfindungsgemäßen Leiterplatte.

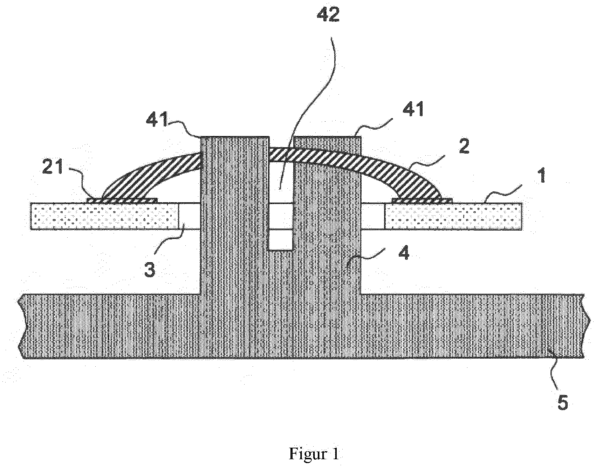

Fig. 1 zeigt ein erstes Ausführungsbeispiel eines erfindungsgemäßen Systems. Dabei ist eine Leiterplatte 1 als flächige Platte im Querschnitt dargestellt. Die Leiterplatte 1 weist einen Haltebügel 2 auf. Der Haltebügel 2 ist als bogenförmige Erhebung oberhalb Leiterplatte 1 mit zwei Lötpunkten 21 als Lötverbindung mechanisch mit der Leiterplatte 1 verbunden. Der Haltebügel 2 ist damit mechanisch lösbar und fixiert mit der Leiterplatte 1 verbunden. Anstelle der Lötpunkte 21 können auch Schweißpunkte, Verschraubungen, Klebungen oder andere mechanische Fixierungen gewählt werden. Der Haltebügel 2 kann als nichtisoliertes Drahtelement ausgebildet sein, beispielweise als Kupferdraht, Nickel- oder Eisendraht. Der Haltebügel 2 kann galvanisch beschichtet sein, zum Beispiel mit Zinn, Silber oder Edelmetallen.

Die Leiterplatte 1 weist zudem eine Durchbohrung 3 auf, welche sich zumindest teilweise unterhalb des Haltebügels 2 befindet. Die Durchbohrung 3 ist dabei von einer ersten Oberseite 11 der Leiterplatte 1 zu einer Unterseite 12 der Leiterplatte 1 ausgebildet. Die Durchbohrung 3 ist insbesondere als Langloch ausgebildet.

Gemäß Fig. 1 ist ein Gehäuse 5 vorgesehen, welches zumindest ein Halteelement 4 aufweist. Dieses Halteelement 4 ist als ein Hochriss ausgebildet. Ein Hochriss ist ein Teil des Gehäuses 5, welches in einem Stanz- und Biegeprozess erhalten wird. Das Halteelement 4 gemäß Fig. 1 weist zwei Haltelaschen 41 auf, die beide gleich ausgebildet sind und mittig durch einen Schlitz 42 getrennt sind. Der Schlitz 42 kann dabei durch Stanzen oder Schneiden erhalten werden.

Um nun das Gehäuse 5 an der Leiterplatte 1 mechanisch zu fixieren, wird das Halteelement 4 von der Unterseite 12 durch die Leiterplatte 1 geführt. An dem auf der Oberseite 11 der Leiterplatte 1 befindlichen Haltebügel 2 werden die Haltelaschen 41 aufgeweitet, sodass der Schlitz 42 zumindest beim Applizieren des Gehäuses an der Leiterplatte 1 kurzzeitig aufgeweitet wird. Der Haltebügel 2 befindet sich nach dem Applizieren des Gehäuses 5 im Bereich des Schlitzes 42 des Halteelements 4.

In Fig. 1 nicht dargestellt ist, dass die Durchbohrung 3 eine Verjüngung 31 aufweist. Mittels dieser Verjüngung 31 und dem Haltebügel 2 wird das Halteelement 4 in der Durchbohrung 3 mechanisch derart fixiert, dass die Haltelaschen 41 an der Verjüngung 31 anliegen und somit mit der Innenwand der Durchbohrung 3 einen physischen Kontakt bilden. Auf diese Weise ist erreicht, dass das Halteelement 4 zwischen die Verjüngung 31 und dem Haltebügel 2 eingespannt ist. Die Bewegungsfreiheit des Halteelements 4 in der Durchbohrung 3 ist somit wesentlich reduziert bzw. nicht mehr vorhanden, sodass insbesondere bei mechanischer Beanspruchung der Leiterplatte 1 relativ zum Gehäuse im Zuge eines Testens oder bei der Inbetriebnahme einer Schaltung auf der Leiterplatte 1 bei Installation in einem Beleuchtungssystem, die Halteverbindung nicht einfach gelöst werden kann und auch nicht unbeabsichtigt verschlechtert wird, insbesondere nicht seine Stabilität verliert bzw. locker wird.

Zudem ist vorgesehen, dass der Haltebügel 2 auch eine elektrische Verbindung zu einem Erdpotential aufweist. Auf diese Weise ist der Haltebügel 2 zudem eine Erdungsleitung. Eine Erdungsleitung ist beispielsweise dann sinnvoll, wenn mittels der Verbindung zwischen dem Gehäuse 5 und der Leiterplatte 1 zudem auch eine elektrische Verbindung geschaffen werden muss, wenn beispielsweise das Gehäuse 5 aus einem metallischen Material besteht. Auf diese Weise ist eine Erdung des Gehäuses 5 und eine gleichzeitige mechanische Fixierung an der Leiterplatte 1 erhalten.

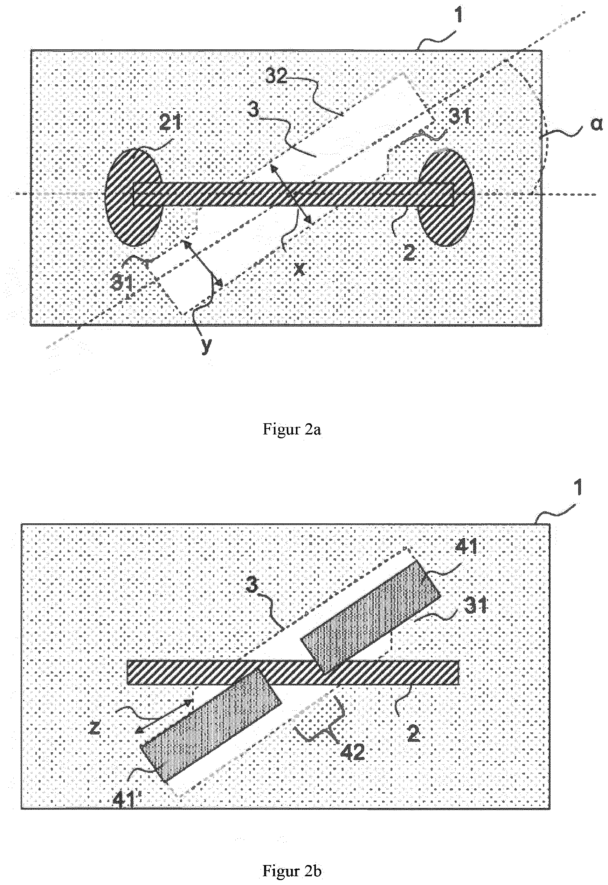

In Fig. 2a ist eine Draufsicht auf eine Oberseite 11 eines ersten Ausführungsbeispiels einer erfindungsgemäßen Leiterplatte 1 gezeigt. Hierbei ist die Draufsicht dargestellt. Zu erkennen ist, dass die Durchbohrung 3 in Form eines Langloches - hier stilistisch als Viereck dargestellt - ausgebildet ist. Die den Längsseiten 32 orthogonalen Querseiten können beispielsweise auch als Halbkreise ausgebildet sein. Das Langloch 3 weist zwei Verjüngungen 31 an entgegengesetzten Längsseiten 32 auf. Die Längsseiten 32 der Durchbohrung 3 sind in einem Winkel α größer o Grad bezogen auf eine Längsausrichtung des Haltebügels 2 angeordnet. Durch Verändern des Winkels α kann die Haltekraft der mechanischen Fixierung eingestellt werden.

Die Verjüngung 31 verjüngt die Durchbohrung 3. Somit ist eine Querabmessung x der Durchbohrung 3 in der Höhe des Haltebügels 2 größer als eine Querabmessung y im Bereich der Verjüngung 31. Die Verjüngung 31 ist beispielsweise als trapezförmiger Vorsprung ausgebildet. Die trapezförmige Ausgestaltung der Vorsprünge 31 ermöglicht es, dass ein Halteelement 4 in einem vergleichsweise großen Bereich der Längsseite 32 der Durchbohrung 3 physisch mit den Innenwänden der Durchbohrung 3 kontaktiert ist. Somit ist die mechanische Fixierung des Gehäuses 5 an der Leiterplatte 1 wesentlich verbessert.

In Fig. 2b ist ein zweites Ausführungsbeispiels eines erfindungsgemäßen Systems dargestellt. Dabei ist die in Fig. 2a beschriebene Leiterplatte 1 mit einem Gehäuse 5 bzw. einem Halteelement 4 des Gehäuses 5 dargestellt. Das Halteelement 4 ist beispielsweise gemäß Fig. 1 ausgebildet und weist zwei Haltelaschen 41, 41' auf, die im Inneren der Durchbohrung 3 platziert sind. Ein Haltebügel 2 trennt die Haltelaschen 41, 41' im Bereich des Schlitzes 42. Da die verjüngende Seite z der Verjüngung 31 über einen signifikanten Teil der Längsseite einer Lasche 41 verläuft, ist erreicht, dass das Halteelement 4 an beiden Seiten des Langlochs 3 mechanisch fixiert ist und mit der Durchbohrung einen physischen Kontakt herstellt. Die Haltelaschen 41, 41' sind dabei mittels der Verjüngung 31 und dem Haltebügel 2 eingespannt. Das führt dazu, dass es zu keinem Auseinanderbiegen der Haltelaschen 41 des Halteelements 4 kommen kann, da die Bewegungsfreiheit der Haltelaschen 41 innerhalb der Durchbohrung 3 massiv eingeschränkt ist, also auch beim Verschieben der Leiterplatte 1 relativ zum Gehäuse 5 kein Lösen des Gehäuses 5 ermöglichen.

Die als Erdungshochriss ausgebildeten Halteelemente 4 des Gehäuses 5 werden somit stärker eingeklemmt als ohne Vorsprünge 31 und fixieren das Gehäuse 5 an der Leiterplatte 1 dauerhaft. Auf diese Weise wird auch eine dauerhaft zuverlässige Erdungsverbindung erreicht.

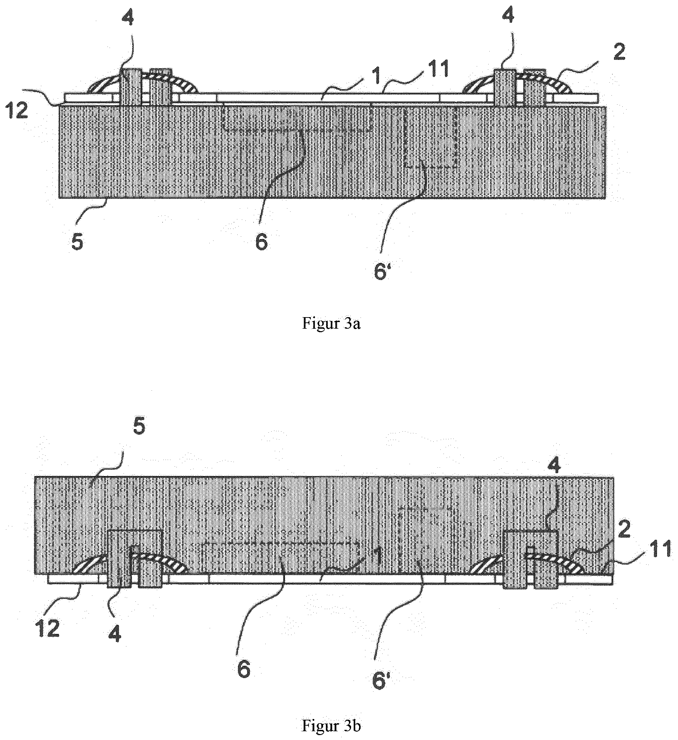

In Fig. 3a ist ein drittes Ausführungsbeispiel eines erfindungsgemäßen Systems dargestellt. Hierbei sind an der Leiterplatte 1 zumindest zwei Haltebügel 2 an den Ecken der Leiterplatte 1 auf einer Oberseite 11 angeordnet. Das Gehäuse 5 weist zumindest zwei Halteelemente 4 auf, die entsprechend der Fig. 1 bzw. der Fig. 2b an dem Haltebügel 2 mechanisch fixiert sind. Zudem ist in der Fig. 3 dargestellt, dass auf einer Unterseite 12 der Leiterplatte 1 Schaltungselemente 6, 6' angeordnet sind, die eine Schaltung zum Betreiben eines Leuchtmittels bilden können. Diese Schaltungselemente 6, 6' sind beispielsweise ein Gleichrichter, ein getakteter Wandler, ein Transformator, eine Batterie als Sekundärspannungsversorgung, sowie Eingangs- und Ausgangsschnittstellen. Um diese Schaltungselemente 6, 6' zu vor äußeren Einflüssen zu schützen, ist vorgesehen, dass das Gehäuse 5 an der Leiterplatte 1 mechanisch fixiert angeordnet ist. Das Gehäuse 5 ist beispielsweise aus Aluminium gefertigt und muss geerdet zu werden. Dazu ist die Verbindung zwischen dem Halteelement 4 und dem Haltebügel 2 zudem auch eine elektrische Kontaktierung mit einem Erdpotential.

In Fig. 3b ist ein viertes Ausführungsbeispiel eines erfindungsgemäßen Systems dargestellt. Im Unterschied zu Fig. 3a ist vorgesehen, dass die Haltebügel 2 auf der gleichen Seite wie die Schaltungselemente 6, 6' ausgebildet sind. Gemäß Fig. 3b ist dies die Oberseite 11 der Leiterplatte 1. Die mechanische Fixierung mittels Haltebügel 2 und Verjüngung 31 ist nicht schlechter als gemäß Fig. 3a, allerdings kann nunmehr auf eine zweiseitige Bestückung der Leiterplatte 1 verzichtet werden. Dies vereinfacht den Herstellungsaufwand und verringert die Bauhöhe des Systems, da die Höhe der Haltebügel 2 kleiner ist als die Höhe der Schaltungselemente 6, 6'.

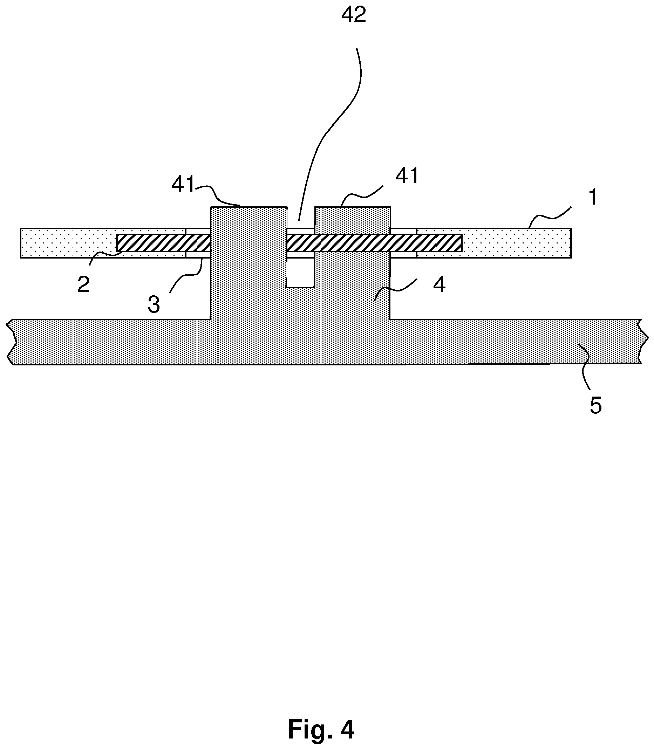

In Fig. 4 ist ein fünftes Ausführungsbeispiel eines erfindungsgemäßen Systems dargestellt. Im Unterschied zu Fig. 1 ist der Haltebügel 2 im Inneren der Leiterplatte 1, also zwischen der Oberseite 11 und der Unterseite 12 angeordnet. Dies verringert die Bauhöhe des Systems und verbessert die mechanische Stabilität der Verbindung des Haltebügels 2 mit der Leiterplatte 1.

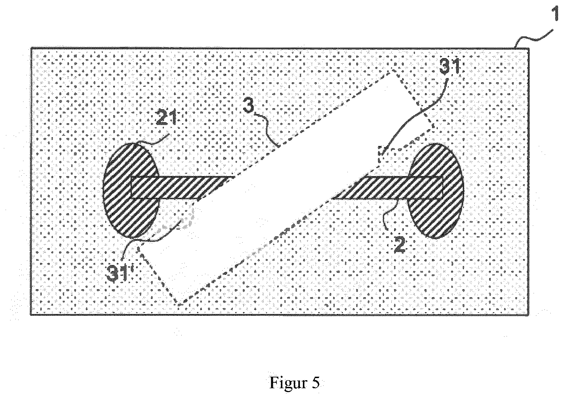

In Fig. 5 ist ein zweites Ausführungsbeispiel einer Leiterplatte 1 in Draufsicht dargestellt. Im Unterschied zur Fig. 2a sind die Vorsprünge 31 alternativ ausgeformt. Gemäß dem linken Vorsprung 31' ist eine halbrunde Auswölbung in das Innere der Durchbohrung 3 vorgesehen. Dementgegen ist der rechte Vorsprung 31 dreieckförmige ausgestaltet. Die in Fig. 5 dargestellte Ausführungsform einer Leiterplatte 1 stellt klar, dass die Verjüngung 31 lediglich derart ausgestaltet sein muss, dass sie das Halteelement 4 bzw. entsprechende Haltelaschen 41, 41' in der Durchbohrung 3 in ihrem Bewegungsradius hemmt beziehungsweise vollständig einspannt.

### Bezugszeichenliste

- 1: Leiterplatte
- 11: Oberseite
- 12: Unterseite
- 2: Haltebügel, Masseleitung
- 21: Lötpunkt
- 3: Durchbohrung, Langloch
- 31: Verjüngung, Vorsprung
- 32: Längsseite
- 4: Halteelement
- 41, 41': Haltelasche
- 42: Schlitz
- 5: Gehäuse
- 6,6': Schaltungselemente
- x: Querabmessung unterhalb des Haltebügels
- y: Querabmessung im Bereich der Verjüngung
- z: verjüngende Seite der Verjüngung
- α: Winkel zwischen Haltebügel und Durchbohrung

## Patentansprüche

1. System für eine Schaltung zum Betreiben zumindest eines Leuchtmittels, bestehend aus einer Leiterplatte (1) und einem Gehäuse (5),
wobei die Leiterplatte (1) aufweist:
- eine flächige Oberseite (11);
- ein Haltebügel (2), auf der flächigen Oberseite (11) der Leiterplatte (1) oder im Inneren der Leiterplatte (1) angeordnet und mechanisch mit der Leiterplatte (1) verbunden; und
- eine Durchbohrung (3), die zumindest teilweise unterhalb des Haltebügels (2) angeordnet ist;
wobei die Durchbohrung (3) zumindest eine Verjüngung (31) aufweist,
wobei das Gehäuse (5) zum Schutz der Leiterplatte (1) mittels des Haltebügels (2) und der Verjüngung (31) mechanisch fixiert ist,
wobei die Durchbohrung (3) bei Draufsicht auf die Leiterplatte (1) ein Langloch ist,
wobei bei Draufsicht auf die Oberseite (11) die Durchbohrung (3) den Haltebügel (2) in einem Winkel größer o Grad kreuzt,
wobei das Gehäuse (5) zumindest ein Halteelement (4) aufweist, welches in der Durchbohrung (3) platziert ist, um das Gehäuse (5) mittels des Haltebügels (2) und der Verjüngung (31) mechanisch an der Leiterplatte (1) zu fixieren,
wobei das Halteelement (4) zumindest zwei Haltelaschen (41) und einen zwischen den Haltelaschen (41) angeordneten Schlitz (42) umfasst,
wobei der Haltebügel (2) der Leiterplatte (1) bei mechanischer Fixierung des Gehäuses (5) an der Leiterplatte (1) durch den Schlitz (42) verläuft, sodass jeweils eine Haltelasche (41) auf einer Seite des Haltebügels (2) bei Draufsicht angeordnet ist, und
wobei jede Haltelasche (41) des Halteelements (4) durch die Verjüngung (31) und den Haltebügel (2) in der Durchbohrung (3) mechanisch fixiert ist.

2. System nach Anspruch 1,
wobei der Haltebügel (2) elektrisch leitend mit einem Erdpotenzial verbunden ist.

3. System nach einem der Ansprüche 1 oder 2,
wobei, wenn der Haltebügel (2) auf der Oberseite (11) angeordnet ist, die Längsseiten (32) des Langlochs in einem Winkel (α) größer o Grad, bevorzugt größer 10 Grad, mehr bevorzugt größer 30 Grad unterhalb des Haltebügels (2) verläuft.

4. System nach einem der vorhergehenden Ansprüche,
wobei zumindest zwei Verjüngungen (31) an entgegengesetzten Längsseiten (32) der Durchbohrung (3) angeordnet sind.

5. System nach einem der vorhergehenden Ansprüche,
wobei die zumindest eine Verjüngung (31) trapezförmig ausgebildet ist; und
wobei eine verjüngende Seite (z) der Verjüngung (31) parallel zu einer Längsseite (32) der Durchbohrung (3) verläuft.

6. System nach einem der vorhergehenden Ansprüche,
wobei Schaltungselemente (6, 6') einer Schaltung zum Betreiben eines Leuchtmittels auf einer der Oberseite (11) gegenüberliegenden Unterseite (12) der Leiterplatte (1) angeordnet sind.

7. System nach einem der Ansprüche 1 bis 5,
wobei Schaltungselemente (6, 6') einer Schaltung zum Betreiben eines Leuchtmittels auf der Oberseite (11) der Leiterplatte (1) angeordnet sind.

8. System nach einem der vorhergehenden Ansprüche,
wobei der auf der Oberseite (11) angeordnete Haltebügel (2) mittels Lötverbindung (21) auf der Leiterplatte (1) angeordnet ist.

9. System nach einem der vorhergehenden Ansprüche,
wobei mittels der Verjüngung (31) die Durchbohrung (3) um mindestens 10 Prozent, bevorzugt 15 Prozent, mehr bevorzugt 20 Prozent verjüngt ist.

10. System nach einem der vorhergehenden Ansprüche,
wobei das Halteelement (4) ein Hochriss aus dem Gehäuse (5) ist.

11. System nach einem der vorhergehenden Ansprüche,
wobei die zumindest eine Haltelasche (41) des Halteelements (4) eine Längsseite (32) aufweist und diese Längsseite (32) der Haltelasche (41) zumindest zu 25 Prozent an einer verjüngenden Seite (z) der Verjüngung (31) anliegt.

12. Verfahren zum mechanischen Fixieren eines Gehäuses (5) an einer Leiterplatte (1), die eine flächige Oberseite (11) aufweist, aufweisend die nachfolgenden Verfahrensschritte:
Anordnen eines Haltebügels (2) mittels Lötverbindung (21) auf der Oberseite (11) der Leiterplatte (1) oberhalb einer zumindest eine Verjüngung (31) aufweisenden Durchbohrung (3) oder Anordnen eines Haltebügels (2) im Inneren der Leiterplatte (1) in einer zumindest eine Verjüngung (31) aufweisenden Durchbohrung (3);
Platzieren eines Halteelements (4) des Gehäuses (5) im Inneren der Durchbohrung (3);
wobei das Halteelement (4) zumindest zwei Haltelaschen (41) und einen zwischen den Haltelaschen (41) angeordneten Schlitz (42) aufweist; und
wobei der Haltebügel (2) durch den Schlitz (42) geführt ist, sodass das Halteelement (4) durch den Haltebügel (2) und die Verjüngung (31) mechanisch fixiert ist und jeweils eine Haltelasche (41) auf einer Seite des Haltebügels (2) bei Draufsicht angeordnet ist,
wobei die Durchbohrung (3) bei Draufsicht auf die Leiterplatte (1) ein Langloch ist,
wobei bei Draufsicht auf die Oberseite (11) die Durchbohrung (3) den Haltebügel (2) in einem Winkel größer o Grad kreuzt, und
wobei jede Haltelasche (41) des Halteelements (4) durch die Verjüngung (31) und den Haltebügel (2) in der Durchbohrung (3) mechanisch fixiert ist.

## Claims

1. System for a circuit for operating at least one illuminant,
consisting of a printed circuit board (1) and a housing (5),
wherein the printed circuit board (1) comprises:
a flat upper side (11);
a retaining bracket (2), arranged on the flat upper side (11) of the printed circuit board (1) or in the interior of the printed circuit board (1) and mechanically connected to the printed circuit board (1); and
a through-hole (3) arranged at least partially below the retaining bracket (2);
wherein the through-hole (3) has at least one taper (31), wherein the housing (5) is mechanically fastened by means of the retaining bracket (2) and the taper (31) in order to protect the printed circuit board (1),
wherein the through-hole (3) is an elongated hole in a plan view of the printed circuit board (1),
wherein, in a plan view of the upper side (11), the through-hole (3) crosses the retaining bracket (2) at an angle greater than 0 degrees,
wherein the housing (5) has at least one retaining element (4), which is placed in the through-hole (3) in order to mechanically fasten the housing (5) to the printed circuit board (1) by means of the retaining bracket (2) and the taper (31),
wherein the retaining element (4) comprises at least two retaining tabs (41) and a slot (42) arranged between the retaining tabs (41),
wherein the retaining bracket (2) of the printed circuit board (1) extends through the slot (42) when the housing (5) is mechanically fastened to the printed circuit board (1), so that in each case a retaining tab (41) is arranged on a side of the retaining bracket (2) in a plan view, and
wherein each retaining tab (41) of the retaining element (4) is mechanically fastened in the through-hole (3) by the taper (31) and the retaining bracket (2).

2. System according to Claim 1,
wherein the retaining bracket (2) is electrically conductively connected to a ground potential.

3. System according to either Claim 1 or 2,
wherein, if the retaining bracket (2) is arranged on the upper side (11), the longitudinal sides (32) of the elongated hole will extend at an angle (a) greater than 0 degrees, preferably greater than 10 degrees, more preferably greater than 30 degrees below the retaining bracket (2).

4. System according to any one of the preceding claims,
wherein at least two tapers (31) are arranged on opposite longitudinal sides (32) of the through-hole (3).

5. System according to any one of the preceding claims,
wherein the at least one taper (31) is trapezoidal; and
wherein a tapering side (z) of the taper (31) extends parallel to a longitudinal side (32) of the through-hole (3).

6. System according to any one of the preceding claims,
wherein circuit elements (6, 6') of a circuit for operating an illuminant are arranged on an underside (12) of the printed circuit board (1) opposite the upper side (11).

7. System according to any one of Claims 1 to 5,
wherein circuit elements (6, 6') of a circuit for operating an illuminant are arranged on the upper side (11) of the printed circuit board (1).

8. System according to any one of the preceding claims,
wherein the retaining bracket (2) arranged on the upper side (11) is arranged on the printed circuit board (1) by means of a solder connection (21).

9. System according to any one of the preceding claims,
wherein the through-hole (3) is tapered at least 10 percent, preferably 15 percent, more preferably 20 percent by means of the taper (31).

10. System according to any one of the preceding claims,
wherein the retaining element (4) is a projection from the housing (5).

11. System according to any one of the preceding claims,
wherein the at least one retaining tab (41) of the retaining element (4) has a longitudinal side (32) and this longitudinal side (32) of the retaining tab (41) bears at least to 25 percent on a tapering side (z) of the taper (31).

12. Method for mechanically fastening a housing (5) to a printed circuit board (1), which has a flat upper side (11), comprising the following method steps:
arranging a retaining bracket (2) by means of a solder connection (21) on the upper side (11) of the printed circuit board (1) above a through-hole (3) having at least one taper (31) or arranging a retaining bracket (2) in the interior of the printed circuit board (1) in a through-hole (3) having at least one taper (31);
placing a retaining element (4) of the housing (5) inside the through-hole (3);
wherein the retaining element (4) has at least two retaining tabs (41) and a slot (42) arranged between the retaining tabs (41); and
wherein the retaining bracket (2) is guided through the slot (42), so that the retaining element (4) is mechanically fastened by the retaining bracket (2) and the taper (31), and a retaining tab (41) is arranged on one side of the retaining bracket (2) in a plan view,
wherein the through-hole (3) is an elongated hole in a plan view of the printed circuit board (1),
wherein, in a plan view of the upper side (11), the through-hole (3) crosses the retaining bracket (2) at an angle greater than or equal to 0 degrees, and
wherein each retaining tab (41) of the retaining element (4) is mechanically fastened in the through-hole (3) by the taper (31) and the retaining bracket (2).

## Revendications

1. Système pour un circuit de commande d'au moins un moyen d'éclairage, constitué d'une carte de circuit imprimé (1) et d'un boîtier (5),
la carte de circuit imprimé (1) comportant :
- une face supérieure plane (11) ;
- un étrier de retenue (2), disposé sur la face supérieure plane (11) de la carte de circuit imprimé (1) ou à l'intérieur de la carte de circuit imprimé (1) et relié mécaniquement à la carte de circuit imprimé (1) ; et
- un trou débouchant (3), qui est disposé au moins en partie en dessous de l'étrier de retenue (2) ;
le trou débouchant (3) comportant au moins un rétrécissement (31), le boîtier (5) pour la protection de la carte de circuit imprimé (1), étant fixé mécaniquement au moyen de l'étrier de retenue (2) et du rétrécissement (31),
le trou débouchant (3) vu du dessus de la carte de circuit imprimé (1) étant un trou oblong,
sur une vue de dessus de la face supérieure (11), le trou débouchant (3) croisant l'étrier de retenue (2) selon un angle supérieur à o degré,
le boîtier (5) comportant au moins un élément de retenue (4), qui est placé dans le trou débouchant (3), afin de fixer mécaniquement le boîtier (5) au moyen de l'étrier de retenue (2) et du rétrécissement (31) à la carte de circuit imprimé (1),
l'élément de retenue (4) comprenant au moins deux pattes de retenue (41) et une fente (42) disposée entre les pattes de retenue (41),
l'étrier de retenue (2) de la carte de circuit imprimé (1) s'étendant à travers la fente (42) lors de la fixation mécanique du boîtier (5) sur la carte de circuit imprimé (1), de sorte que, respectivement, une patte de retenue (41) soit disposée sur un côté de l'étrier de retenue (2) sur une vue de dessus et
chaque patte de retenue (41) de l'élément de retenue (4) étant fixée mécaniquement par le biais du rétrécissement (31) et de l'étrier de retenue (2) dans le trou débouchant (3).

2. Système selon la revendication 1,
l'étrier de retenue (2) étant connecté de manière électroconductrice avec un potentiel de terre.

3. Système selon l'une quelconque des revendications 1 ou 2,
lorsque l'étrier de retenue (2) est disposé sur la face supérieure (11), les faces longues (32) du trou oblong s'étendant selon un angle (a) supérieur à o degré, de préférence supérieur à 10 degrés, plus préférablement supérieur à 30 degrés en dessous de l'étrier de retenue (2).

4. Système selon l'une quelconque des revendications précédentes,
au moins deux rétrécissements (31) étant disposés sur les faces longues (32) opposées du trou débouchant (3).

5. Système selon l'une quelconque des revendications précédentes,
l'au moins un rétrécissement (31) étant conçu de forme trapézoïdale ; et
une face se rétrécissant (z) du rétrécissement (31) s'étendant parallèlement à une face longue (32) du trou débouchant (3).

6. Système selon l'une quelconque des revendications précédentes,
des éléments de circuit (6, 6') d'un circuit de commande d'un moyen d'éclairage étant disposés sur une face inférieure (12) de la carte de circuit imprimé (1) opposée à la face supérieure (11).

7. Système selon l'une quelconque des revendications 1 à 5,
des éléments de circuit (6, 6') d'un circuit de commande d'un moyen d'éclairage étant disposés sur la face supérieure (11) de la carte de circuit imprimé (1).

8. Système selon l'une quelconque des revendications précédentes,
l'étrier de retenue (2) disposé sur la face supérieure (11) étant disposé au moyen d'une liaison par soudure (21) sur la carte de circuit imprimé (1).

9. Système selon l'une quelconque des revendications précédentes,
le trou débouchant (3) étant rétréci, au moyen du rétrécissement (31), d'au moins 10 pour cent, de préférence 15 pour cent, plus préférablement 20 pour cent.

10. Système selon l'une quelconque des revendications précédentes, l'élément de retenue (4) étant une saillie à partir du boîtier (5).

11. Système selon l'une quelconque des revendications précédentes,
l'au moins une patte de retenue (41) de l'élément de retenue (4) présentant une face longue (32) et cette face longue (32) de l'élément de retenue (41) s'appuie au moins à 25 pour cent sur la face se rétrécissant (z) du rétrécissement (31).

12. Procédé de fixation mécanique d'un boîtier (5) sur une carte de circuit imprimé (1), qui comporte une face supérieure plane (11), comportant les étapes de procédé suivantes :
disposition d'un étrier de retenue (2) au moyen d'une liaison par soudure (21) sur la face supérieure (11) de la carte de circuit imprimé (1) au-dessus d'un trou débouchant (3) comportant au moins un rétrécissement (31) ou disposition d'un étrier de retenue (2) à l'intérieur de la carte de circuit imprimé (1) dans un trou débouchant (3) comportant au moins un rétrécissement (31) ;
placement d'un élément de retenue (4) du boîtier (5) à l'intérieur du trou débouchant (3) ;
l'élément de retenue (4) comportant au moins deux pattes de retenue (41) et une fente (42) disposée entre les pattes de retenue (41) ; et
l'étrier de retenue (2) étant guidé à travers la fente (42), de sorte que l'élément de retenue (4) soit fixé mécaniquement par le biais de l'étrier de retenue (2) et du rétrécissement (31) et qu'une patte de retenue (41) soit respectivement disposée sur une face de l'étrier de retenue (2) sur une vue de dessus,
le trou débouchant (3) vu du dessus de la carte de circuit imprimé (1) étant un trou oblong,
sur une vue de dessus de la face supérieure (11), le trou débouchant (3) croisant l'étrier de retenue (2) selon un angle supérieur à o degré et
chaque patte de retenue (41) de l'élément de retenue (4) étant fixée mécaniquement par le biais du rétrécissement (31) et de l'étrier de retenue (2) dans le trou débouchant (3).
